# EUROPEAN PATENT APPLICATION

(11) **EP 3 273 495 A1**
(43) Date of publication of application: **24.01.2018**
(21) Application number: 16305953.8
(22) Date of filing: 22.07.2016
(51) Int. Cl.: H01L 51/44, H01L 51/52

(54) **DEVICE COMPRISING NANOWIRES**

(71) Applicant: Université de Strasbourg, 67000 Strasbourg (FR); Centre National de la Recherche Scientifique, 75016 Paris (FR)
(72) Inventor: ZHANG, Lei, 67000 STRASBOURG (FR); SAMORI, Paolo, 67000 STRASBOURG (FR); ORGIU, Emanuele, 67100 STRASBOURG (FR); ZHONG, Xiaolan, 67000 STRASBOURG (FR); LI, Song-Lin, 210023 Nanjing (CN); EBBESEN, Thomas, 67000 STRASBOURG (FR)
(74) Representative: Lavoix

(57) **Abstract**

The present invention relates to a device comprising a top electrode and a bottom electrode, wherein said top electrode comprises nanoholes and wherein said device comprises nanowires comprising alternative contact areas with said top electrode and with said bottom electrode, said contact areas on the top electrode being (i) located on the top surface of said top electrode and said contact areas on the bottom electrode being (i) located on the top surface of the bottom electrode facing the top electrode and (ii) located in nanoholes of said top electrode; to method or process for fabricating such a device; and applications thereof.

## Description

The present invention concerns devices for optoelectronic applications. In particular, the present invention relates to novel devices exhibiting high absorption coefficient and remarkable light sensitivity. In particular, the present invention relates to novel devices comprising nanowires.

Semiconducting supramolecular nanowires (SMNWs) are versatile nanostructures that combine the advantages of soft materials like polymers in terms of flexibility and low-cost solution-processability with the physical and chemical characteristics of organic crystals. Along the nanowire, photo-generated charge carriers can be transported efficiently to reach the electrodes by virtue of optimal π-electron overlapping. In view of their high surface/bulk aspect ratio, nanowires are particularly suitable for exciton dissociation by minimizing the diffusion length from the bulk to the interface where exciton separation typically occurs. The other advantages of using SMNWs for photonic applications include lower interface reflection loss compared to thin-film, together with tunable optoelectronic properties by rational molecular design and by aggregation. More recently, long-range exciton transport, i.e. up to a few microns, has also been reported in supramolecular nanowires (Haedler, A.T. et al. Long-range energy transport in single supramolecular nanofibres at room temperature. Nature 523, 196-199 (2015*)).* All these outstanding characteristics make SMNWs ideal active components for light energy harvesting and optical detection in photonic devices. Additionally, nanowire based photonic devices represent perfect platforms for studying how the order at the supramolecular level affects the photoelectrical conversion, being an essential knowledge to be gathered for technologically relevant applications such as organic photovoltaics (OPVs) and photodetectors.

Hitherto, a variety of SMNWs have been synthesized and investigated. Some of them have been exploited for the fabrication of organic field-effect transistors (OFETs) and phototransistors displaying promising optoelectronic properties (EI Gemayel, M. et al. Tuning the photoresponse in organic field-effect transistors. J. Am. Chem. Soc. 134, 2429-2433 (2012*);* Sagade, A.A. et al. High-mobility field effect transistors based on supramolecular charge transfer nanofibres. Adv. Mater. 25, 559-564 (2013*);* Hollamby, M.J. et al. Directed assembly of optoelectronically active alkyl-pi-conjugated molecules by adding n-alkanes or pi-conjugated species. Nature Chem. 6, 690-696 (2014*)).* However, photovoltaic devices based solely on organic nanowires (NWs) are rarely reported because of the difficulty associated with the creation of controlled (nano)interfaces with the electrodes where the dissociated exciton should be collected. In order to efficiently harvest photocurrent from nanowires, one of the prerequisites is to interface them with an external circuit possessing asymmetric (nano)electrodes. On the same time, the nanoelectrodes should also cover large areas in order to incorporate as many nanowires as possible. Since low-cost production represents one of the advantages of SMNWs, the fabrication of the nanoelectrodes cannot represent the major hurdle to their full integration in everyday electronics. Although these requirements could be satisfied in thin-film vertical diode configuration, unfortunately such approach is not applicable to neat one-dimensional semiconductors because NWs alone would not form an even and pinhole-free layer to sustain the top electrode without the addition of an extra strengthening layer of polymer. Overall, the strategy to make electrical contact with bottom-up nanostructures is still a long-standing research topic in supramolecular electronics. Madaria et al. in the publication "Toward Optimized Light Utilization in Nanowire Arrays Using Scalable Nanosphere Lithography and Selected Area Growth" (Nano Lett., 2012, 12 (6), pp 2839-2845; DOI: 10.1021/nI300341) described a method for preparing scaffold including vertically aligned semiconducting nanowires. Such preparation process remains complex because of nanowires growth and can be further improved in term of device geometry for optoelectronic applications.

The present invention aims to solve one or more, preferably all of, the above technical problems.

The present invention aims to solve the technical problem of providing a device with easy connection of nanowires.

The present invention also aims to solve the technical problem of providing a device having a good signal/noise ratio, preferably higher than 10⁵, and more preferably higher than 10⁶.

The present invention also aims to solve the technical problem of providing a device having a good response time, preferably lower than 20 nanosecond, preferably of the order of 10 nanosecond.

The present invention also aims to solve the technical problem of providing a device having a good quantum efficiency, preferably higher than 40%, and more preferably higher than 50%.

The present invention also aims to solve the technical problem of providing a device having asymmetric electrodes (nanoelectrodes).

The present invention also aims to solve the technical problem of providing a device that does not require sandwich geometry, especially in one dimensional semiconductors geometry.

The present invention also aims to solve the technical problem of providing a device that does not require a transparent electrode, especially in one dimensional semiconductors geometry.

The present invention also aims to solve the technical problem of providing a low cost production of such devices.

The inventors have discovered that a device according to the present invention solves one or more, preferably all of, the above technical problems.

The present invention relates to a novel device comprising a top electrode and a bottom electrode, wherein said top electrode comprises nanoholes and wherein said device comprises nanowires comprising alternative contact areas with said top electrode and with said bottom electrode, said contact areas on the top electrode being (i) located on the top surface of said top electrode and said contact areas on the bottom electrode being (i) located on the top surface of the bottom electrode facing the top electrode and (ii) located in nanoholes of said top electrode.

The present invention relates to a novel device based on an unprecedented vertical-channel nanomesh scaffold to support and connect nanowires, preferably asymmetrically.

In particular, the resulting photonic device shows high external quantum efficiency when in resonance, ultrafast photoresponse and ultrahigh signal/noise ratio because of the efficient charge and exciton transport in nanowires.

### SMNWs

In the present invention, nanowires are abbreviated as "NWs" or also called nanofilaments.

In one embodiment, said nanowires are curvilinear.

In one embodiment, said nanowires are unoriented, such lack of orientation is advantageous for making a device with uniform response from all the directions. In addition, the non-orientation is also time-saving because an extra effort to align the nanowires can be avoided.

In one embodiment, said nanowires are oriented. Such orientation is advantageous for properties that depend on the vectorial fields such as electric and magnetic field. Such oriented nanowires offer higher wiring density without overlapping.

According to a specific embodiment, said nanowires comprise molecules exhibiting slipped π-π stacking along [100] direction corresponding to the long axis of the nanowire, thereby favouring efficient in-plane charge carrier transport.

In one embodiment, said nanowires comprise at least one organic component.

In one embodiment, said nanowires comprise at least one inorganic component.

In one embodiment, said nanowires comprise at least one metallic component.

In one embodiment, said nanowires comprise organic dye-aggregates.

Advantageously, said nanowires comprise one or more self-assembled n-type semiconductors.

In one specific embodiment, said nanowires comprise at least one component selected from the perylenedicarboximides, and specifically of *N,N'*-Dioctyl-3,4,9,10-perylenedicarboximide (PTCDI-C8).

PTCDI-C8 is a commercially available n-type organic semiconductor that self-assembles into NWs thereby forming advantageously semiconducting supramolecular nanowires.

In one embodiment, nanowire starts to make conformal contact with the bottom electrode at distance of more than 50 nm, for example more than 100 nm, from the nanohole edge on the surface of the top electrode.

Typically, a nanowire of the invention is partially suspended between the electrodes in between two consecutive contacts.

Advantageously, the diameter of the nanowire is less than the diameter of the nanohole.

Advantageously, the diameter of the nanowire is less than the length of the nanowire.

In one embodiment, said device comprises more than 100 nanowires, and preferably more than 1,000 nanowires.

In one embodiment, said nanowires form a film on the surface of the top electrode. In one embodiment, the NWs form a monolayer or quasi-monolayer thick film.

In one preferred embodiment, more than 80%, and preferably more than 90%, of the nanoholes are accommodating NWs.

In one embodiment, said nanowires are connected to asymmetric electrodes, i.e. electrodes having a different work function.

In one embodiment, said nanowires present a diameter of from 1 to 600 nm, preferably from 5 to 200 nm, for example from 20 to 70 nm.

In one embodiment, contact areas are of from 1 to 20% of the total electrode surface.

In one embodiment, said top electrode comprises more two, preferably at least four, nanowires in a single nanohole.

Advantageously, said device comprises a bottom electrode in contact and superimposed with a dielectric layer, wherein inside said nanoholes a semiconducting layer is in contact and superimposed with the bottom electrode.

Advantageously, said device comprises nanowires comprising or consisting of a n-type semiconducting material, and said device comprises a p-type semiconducting layer in contact and superimposed with said bottom electrode. Accordingly, in such advantageous embodiment, said contact areas form a p-n junction. Such p-n junction comprises superimposition and contact of the n-semiconducting nanowires and the layer the p-semiconducting material.

### Nanomesh scaffold

The nanomesh scaffold is formed by the layers having nanoholes. This scaffold comprises typically the top electrode and the optional dielectric layer.

Patterned by nanospheres lithography (NSL), the scaffold advantageously comprises millions of hole-shaped electrodes (also called "nanoelectrodes") in hexagonal array.

In one embodiment, nanohole channel length is below or equal to 100 nm (this represents the vertical height of the nanohole). In other words, said nanoholes present a height lower or equal to 100 nm. This channel length is ready to be adjusted by adopting dielectric layer with different thickness from 10 nm to a few hundreds nanometres, for example to 200 nm or to 400 nm.

The height difference between top and bottom electrodes also enables zone-selective modification with a series of organic/polymeric semiconductors to further tune the asymmetry.

In one embodiment, the scaffold presents more than 10,000, and preferably more than 1,000,000 nanoholes.

According to one aspect, the invention relates to a device comprising a top electrode surfacing a dielectric layer, said dielectric layer surfacing a bottom electrode.

Typically, said top electrode and said dielectric layer comprise nanoholes. Preferably nanoholes of the top electrode are facing the nanoholes of the dielectric layer. In other words a same nanohole if formed in both the top electrode and the dielectric layer.

For example the dielectric layer comprises or consists of SiO₂. In one embodiment, the dielectric layer has a thickness of 10 to 500 nm, preferably from 50 to 200 nm, typically of about 100 nm.

In one embodiment, said device presents a layer of one or more semiconducting components inside said nanoholes, on the bottom electrode top surface.

According to a specific embodiment, the nanomesh scaffold comprises organic crystals inside nanoholes, for example by selectively crystal seeding and growing, in particular in order to flatten and smoothen the nanomesh scaffold surface.

### Electrodes

In one embodiment, said top electrode presents an array of hexagonal nanoholes.

In one embodiment, said top electrode presents a periodic nanostructure of nanoholes.

In one embodiment, said top electrode presents more than 10,000, and preferably more than 1,000,000 nanoholes.

In one embodiment, the top electrode comprises nanoholes having a diameter of from 100 to 2000 nm, for example from 300 to 1500 nm, and for example from 400 to 1200 nm.

In one embodiment, said electrodes are asymmetric. In one embodiment, said electrode is a metallic, for example gold, cathode, or conductive polymer cathode like PEDOT:PSS and PANI, or conductive carbon materials like for example graphene.

In one embodiment, said electrode is a silicon anode, p-doped Si, p-doped Ge or p-doped SiGe. The other conductive materials are also possibly exploited as anode including polymeric conductor like PEDOT:PSS and PANI, metallic ones like gold, copper and silver, carbon materials like for example graphene.

According to the invention, the bottom electrode could comprise a hole conducting polymer such as a p-type semiconducting polymer.

In one embodiment, said electrode is a silicon anode covered by a layer of a p-type semiconducting polymer. Such polymer is for example selected from the group consisting of P3HT, P3OT, MEH-PPV (poly[2-méthoxy-5-(2-éthyl-hexyloxy)-1,4-phénylène-vinylène]), PEDOT, F8T2 (poly(9,9-di-n-octylfluorene-alt-benzothiadiazole)), IIDDT-C3, PQT-12 Poly(3,3"'-didodecyl quarter thiophene), PBTTT Poly[2,5-bis(thiophen-2-yl)thieno[3,2-b]thiophene], etc and any mixture thereof.

Advantageously, in order to enhance hole-selectivity and suppress non-radiative recombination at Si/NWs interface, the Si could be modified with a layer of p-type semiconducting polymer, inhibiting electron transfer from the n-type semiconductor of said NWs, for example PTCDI-C8, to the Si electrode by forming p-n junction with the n-type semiconductor (PTCDI-C8) SMNWs.

In one embodiment, the bottom electrode is a n-doped material; Preferably, the bottom electrode is a n-doped Si layer. In one embodiment, the bottom electrode is a n-doped material; for example the bottom electrode is a p-doped Si layer.

### Preparation of the device

The present invention also relates to a method or process for fabricating a device according to the present invention, said method of process comprising:
(a) Preparing a scaffold comprising nanoholes in a top electrode, said top electrode being on the top surface of a bottom electrode,
(b) Preparing a film of nanowires;
(c) Depositing said film of nanowires on the top surface of the top electrode;
(d) Contacting said nanowires by alternative contact areas with said top electrode and with said bottom electrode, said contact areas on the top electrode being (i) located on the top surface of said top electrode and said contact areas on the bottom electrode being (i) located on the top surface of the bottom electrode facing the top electrode and (ii) located in nanoholes of said top electrode.

In one embodiment, said step a) of preparing a scaffold comprising nanoholes, comprises preparing a top electrode and forming nanoholes in said top electrodes by nanospheres lithography. Nanospheres lithography is already known in the art. Reference is made to Sinitskii, A. & Tour, J.M. Patterning graphene through the self-assembled templates: toward periodic two-dimensional graphene nanostructures with semiconductor properties. J. Am. Chem. Soc. 132, 14730-14732 (2010*)* and Gao, T.C., Wang, B.M., Ding, B., Lee, J.K. & Leu, P.W. Uniform and ordered copper nanomeshes by microsphere lithography for transparent electrodes. Nano Lett. 14, 2105-2110 (2014*).*

Nanospheres lithography (NSL) refers to a patterning approach that utilizes hexagonal close-packed (hcp) nanospheres monolayer as mask on a top electrode. By combining additive- and subtractive-process, NSL offers a versatile method to fabricate large-area and periodic nanostructures with different materials like metals, graphene, semiconductors *etc.*

In one embodiment, the process or method comprises depositing nanospheres hcp-monolayer on a dielectric layer, typically a SiO₂ layer, surfacing a bottom electrode.

Advantageously, a treatment, such as for example oxygen plasma, is applied to widen the gap between adjacent nanospheres.

Preferably, the nanospheres form a monolayer.

Preferably, the honeycomb-like hole-array scaffold presents a periodicity of the nanoholes dispersion.

In one embodiment, said device comprises a dielectric layer surfacing said bottom electrode, and said method or process comprises removing from said nanoholes said dielectric layer by reactive ion etching.

A top electrode is deposited on the dielectric layer, for example by high-vacuum thermal evaporation, followed by a lift-off step to remove the nanospheres. This forms advantageously a top electrode nanomesh including nanoholes.

Advantageously, after the lift-off step, the top electrode nanomesh serves as a mask to remove the dielectric layer. In one preferred embodiment, said removal of the dielectric layer is performed by reactive ion etching (RIE).

Advantageously, the inter-electrode distance in the device of the invention is determined by the dielectric layer thickness.

Advantageously, the exposed surface of the bottom electrode forms the counter-electrode.

For example, the top electrode on a substrate (for example SiO₂) is patterned by nanospheres lithography. Then a thin shadow layer (for example of LiF) (∼20 nm) is deposited by shadow mask to define the device surface. The dielectric layer not being protected by top electrode and shadow layer is removed, for example by exposition to plasma. Therefore the nanospheres are removed thereby leaving nanoholes in the top electrode surface.

### Electrode modification

The device, method and process according to the invention are extremely versatile, e.g. it is possible to make further modifications inside the nanoholes.

According to one embodiment, the process or method comprises modification of at least one electrode. In one embodiment, said process or method comprises anode modification.

In one embodiment, the bottom electrode is surfaced on the top surface by a semiconductor. In one embodiment, a layer of semiconducting p-type polymer is located on the bottom electrode and inside the nanoholes. In one embodiment, the semiconducting p-type polymer is sandwiched between the NWs and the bottom electrode thereby forming a p-n junction.

In one embodiment, a layer of semiconducting p-type polymer such as for example poly(3-hexylthiophene) (P3HT), is spin-coated without altering the nanomesh morphology. The thickness of the semiconducting p-type polymer layer is thin enough not to alter the nanomesh roughness. If the spin-coated film is too thick, the nanostructured surface would be smoothened.

In one embodiment, a sacrificial layer is deposited onto the surface of the semiconducting p-type polymer layer. This sacrificial layer flattens the surface of the device. The sacrificial layer may be removed by etching, for example by oxygen plasma, to leave only the semiconducting p-type polymer layer inside the nanoholes.

Advantageously, said semiconducting p-type polymer is poly(3-hexylthiophene) (P3HT).

### Film deposition

In one advantageous embodiment, the molecules forming the nanowire were self-assembled into supramolecular nanowires by solvent-induced precipitation (SIP).

In one embodiment, the NWs film floats at the liquid/atmosphere interface (typically water/air interface). In one specific embodiment; a PVP solution was dropped onto the liquid surface to compress the floating NWs into uniform films, before transferring the film onto the nanomesh scaffold. Compared to spin-coating, this assembling approach has two advantages: *i*) the NWs can be even distributed on surfaces, and *ii*) NWs can be deposited at the nanomesh scaffold surface, without waste or limited waste.
After film deposition, the device is subjected to thermal annealing to remove residue water and to enhance the intermolecular interaction in NWs.

Thermal annealing may comprise a thermal treatment at 100°C or more, and can be performed for example at 150°C, at 175°C 200°C or 225°C. The thermal treatment is performed at less than 225°C. Preferably, the treatment is performed at 180°C.

### Solvent

In self-assembled NWs, the size of the NWs can be adjusted for example by mixing the solution of the NWs molecules with a non-solvent, i.e. a bad solvent of said molecules. Such non-solvent are for example alcohols, and more specifically C1-C6 alcohols In one embodiment, methanol, ethanol, propanol (1- or 2), butanol (n-, s- or t-), pentanol, hexanol or any mixture thereof is used as non-solvent. Generally, high boiling point alcohols enable slow molecular diffusion thereby providing longer times for semiconducting molecules to self-assemble and form NWs. As a result, the size (diameter) of the NWs increases monotonically with the number of carbon atoms in the alcohol molecule of the non-solvent. On the one hand, bigger NWs could be beneficial thanks to the enhanced light absorption from thicker active layer. On the other hand, thicker and wider NWs possess increased rigidity.
In one specific embodiment, the nanowires are form using a solution containing ethanol.

### Device and use

In one embodiment, the device of the invention is for use in opto-electronic applications.

In one embodiment, the device of the invention is for use as a photovoltaic device. The device of the invention is therefore in such embodiment a photovoltaic device. This device is typically a p-i-n or n-i-p type photovoltaic cell, an organic transistor or light-emitting diode; the invention particularly concerns an organic photovoltaic cell.

In one embodiment, the device of the invention is for use as a photodetector. The device of the invention is therefore in such embodiment a photodetector.

The invention also relates to a device according to the invention for use in spintronics or in optoelectronic applications. For example, a device according to the invention is for use as nanowire-based light-emitting diodes or spin-valves.

The devices according to the invention are extremely versatile and they can be employed also to other semiconducting nanowires possessing outstanding optoelectronic properties, thereby enabling the fabrication of high performance photovoltaic detectors

In one embodiment, the device according to the invention does not comprise a transparent electrode. More specifically, in one embodiment, the device according to the invention does not comprise an ITO electrode.

In one embodiment, the top electrode forms a plasmonic structure. The top electrode can also potentially act like an antenna to further boost the absorption.

When asymmetrically connected to the electrodes, the NWs exhibit photovoltaic effect under monochromatic visible light.

In one embodiment, the light source is a laser. In one embodiment, said laser presents a wavelength ranging from 300 to 800 nm.

In one embodiment, the light power density is ranging from 0.01 to 1 µW/cm², for example from 0.1 to 0.5 µW/cm².

In one embodiment, the light power density is ranging from 0.1 to 1,000 mW/cm², for example from 100 to 500 mW/cm².

In one embodiment, the laser source has a laser pulse energy of 1 to 100 nJ/cm².

In one embodiment, the Open Circuit Voltage (Voc) is of 0.1 to 1 V, preferably from 0.2 to 0.5V.

In one embodiment, the signal/noise ratio of the photodetector is more than 10⁴, for example from 10⁵ to 10⁷ when the device is 0 V bias.

In one embodiment, the signal/noise ratio of the photoconductor is more than 10, for example from 10³ to 10⁵ when the device is 1.5 V bias.
In one embodiment, the External Quatum Efficieny (EQE) is of more than 20%, preferably more than 40%, more preferably more than 45%, and advantageously of more than 50%. In one embodiment, the photoresponsivity (R) in photovoltaic (PV) mode is of more than 50 mA/W, preferably more than 80 mA/W, more preferably more than 150 mA/W, and advantageously of more than 200 mA/W.
In one embodiment, the photoresponsivity (R) in photoconduction (PC) mode is of more than 0.5 A/W, preferably more than 0.8 A/W, and advantageously of more than 1.5 A/W.

In one embodiment, the device has a good photoresponse time, preferably lower than 20 nanosecond, preferably of the order of 10 nanosecond. Due to the short inter-electrode distance and good charge transport ability, the photodetector devices according to the invention (PC mode) are expected to switch faster than previously reported phototransistors using longer channel lengths.

The invention also relates to a device as defined in the present invention or obtainable from a method or process as defined in the present invention, in an opto-electronic device.

The invention also relates to a method for converting an electromagnetic irradiation in electric energy.

The invention also relates to the use of a device according to the invention as an opto-electronic device, including inorganic based photonic devices, inorganic and organic light-emitting diodes, organic light-emitting transistors, solar cells based on perovskite, organic semiconductors and dyes, water splitting devices.

In the figures
Figure 1 represents a design of a device according to the invention and a method according to the invention for preparing such a device;
Figure 2 shows estimation of the contact area between the NWs and the bottom electrode.
Figure 3 shows Optimized photovoltaic *J- V* curves
Figure 4 shows the main parameters of SMNWs/P3HT photovoltaic device as a function of irradiation wavelength.
Figure 5 shows the photovoltaic effect when irradiated by ultralow light power of 0.018 µW/cm².
Figure 6 represents SEM images and device configuration according to example 9
Figure 7 shows a fast photo response under 1.5 V bias voltage in PTCDI-C8 SMNWs on nanomesh scaffold with and without P3HT modification layer.
Figure 8 shows P-channel OFET transfer curves of three anode modification layers
Figure 9 shows *I*_{d}*-V*_{g} curve for a bottom-gate bottom-contact transistor with IIDDT-C3 as the active layer.
Figure 10 shows a film morphology of three modification layers characterized by AFM. a) P3HT; b) F8T2; c) IIDDT-C3.
Figure 11 shows OFETs based on full-coverage PTCDI-C8 NWs in bottom-contact bottom gate device geometry. Blue lines represent the original transfer curve before high temperature annealing.
Figure 12 represents schematic view of the transient photocurrent measurement. Bias-T is schematically represented by a capacitor (C) and a coil (L). The amplifier was a wide-bandwidth inverting current 53 dB amplifier

### Examples

### Example 1: Preparing a device according to the invention

### Materials

Polystyrene (PS) nanospheres mono-dispersed suspension (10w%, in water), Poly(3-hexylthiophene-2,5-diyl) (Mn 54000-75000, 99.995%), *N,N'*-Dioctyl-3,4,9,10-perylenedicarboximide (98%), Poly(9,9-dioctylfluorene-*alt*-bithiophene) (99.9%) and Poly(4-vinylphenol) (Mw ∼25000) were purchased from Sigma-Aldrich without further purification. The small bandgap p-type polymer of IIDDT-C3 were purchased from 1-Material and used as received. The silicon wafer was purchased from Fraunhofer with 90-nm thick thermally grown SiO₂ dielectric layer (n-doping level ∼3 10¹⁷ cm⁻³).

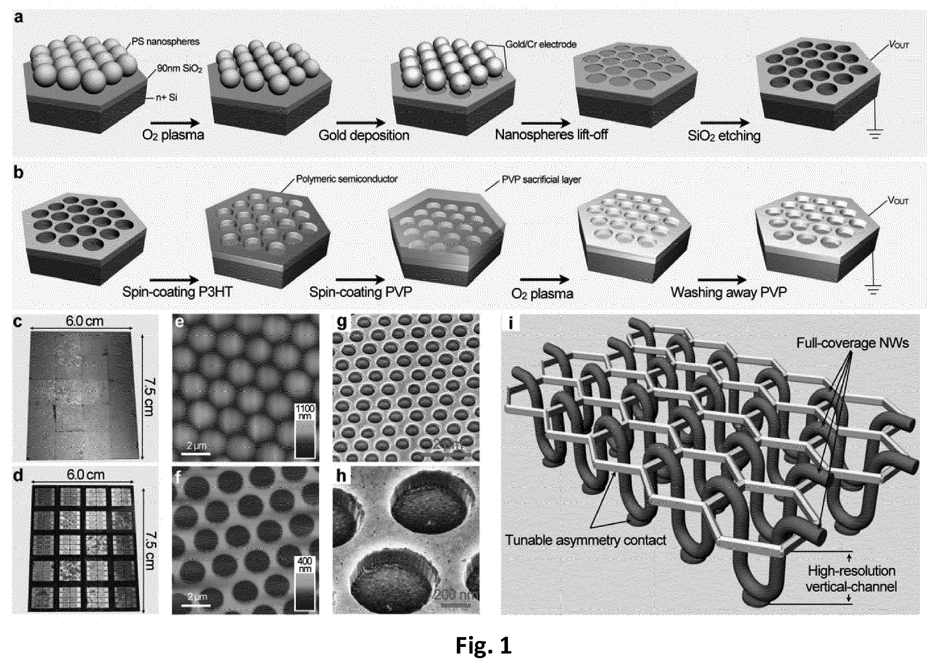

Nanospheres lithography (NSL) refers to a patterning approach that utilizes hexagonal close-packed (hcp) nanospheres monolayer as mask By combining additive- and subtractive-process, NSL offers a versatile method to fabricate large-area and periodic nanostructures with different materials like metals, graphene, semiconductors *etc.* The fabrication procedure starts with the deposition of a polystyrene (PS) nanospheres hcp-monolayer (Fig. 1a). Then oxygen plasma treatment is applied to widen the gap between adjacent PS nanospheres. Au (gold) is then deposited by high-vacuum thermal evaporation followed by a lift-off step. Thereafter, the gold nanomesh serves as a mask to remove SiO₂ dielectric layer by reactive ion etching (RIE).

### Reactive ion etching conditions

The gold nanomesh electrode on top of 90 nm SiO₂ was patterned by nanospheres lithography, according to literature. Then a thin layer of LiF (∼20 nm) was deposited by shadow mask to define the device surface. LiF was chosen as the resist for several reasons: i) it can be easily removable with water. ii) it is electrically inert. iii) It exhibit high corrosion stability in RIE. Using a Plasmalab 80 plus RIE system purchased from Oxford Instruments, the SiO₂ dielectric layer not being protected by gold and LiF would be removed under a condition of 200 W plasma power and 5 sccm C₂F₆/25 sccm Ar mixed gas.

The exposed surface of heavily n-doped Si was designed to act as the counter-electrode. Therefore, the inter-electrode distance in our novel device is determined by the SiO₂ thickness (90 nm in our case). To estimate the yield of fabrication process, we carried out a large device statistics and found that 83% out of the total 160 devices exhibited leakage current below 1 nA at ±1.5 V bias voltage (Surface area: 0.07 cm²).

Significantly, the approach according to the invention is extremely versatile, e.g. it is possible to make further modifications inside the nanohole. Firstly, a thin layer of semiconducting p-type polymer like poly(3-hexylthiophene) (P3HT) was spin-coated without altering the nanomesh morphology. This process is referred to as "conformal spin-coating", which is realized by depositing a very thin film onto a relatively rough surface containing nanostructures. In contrast, if the spin-coated film were much thicker, the nanostructured surface would be smoothened as shown in the second step of Fig. 1b. Here the substrate flattens by poly(4-vinylphenol) (PVP) sacrificial layer was then transferred into an oxygen plasma chamber to "burn off" redundant PVP film. By controlling the etching dose, only P3HT modification layer inside nanoholes is left since PVP could be washed away by ethanol thereafter. For each step of the procedure depicted in Figure 1b, the change in morphology has been characterized by atomic force microscope (AFM).

Figure 1c and d show the photograph images of fully covered PS nanospheres monolayer with 1100 nm sphere diameter and the resulting nanomesh scaffold, respectively. The polychromatic shades originate from light dispersion effects of nanosphere- or hole-array with period comparable to visible light wavelength. Figure 1e and 1f portray the topographical AFM images of samples displayed in Fig. 1c and 1d, respectively. As suggested by the colourful appearance in photograph images, the PS nanospheres monolayer and honeycomb-like hole-array scaffold show high degree of periodicity. The SEM analysis performed at a tilt angle of 54° (see Fig. 1g and 1h) further confirm that *i*) the side walls are vertical and sharp, and *ii*) the gold nanomesh stays on top of dielectric layer without collapsing. The latter observation is in accordance with the low leakage current level measured.

### Anode modification

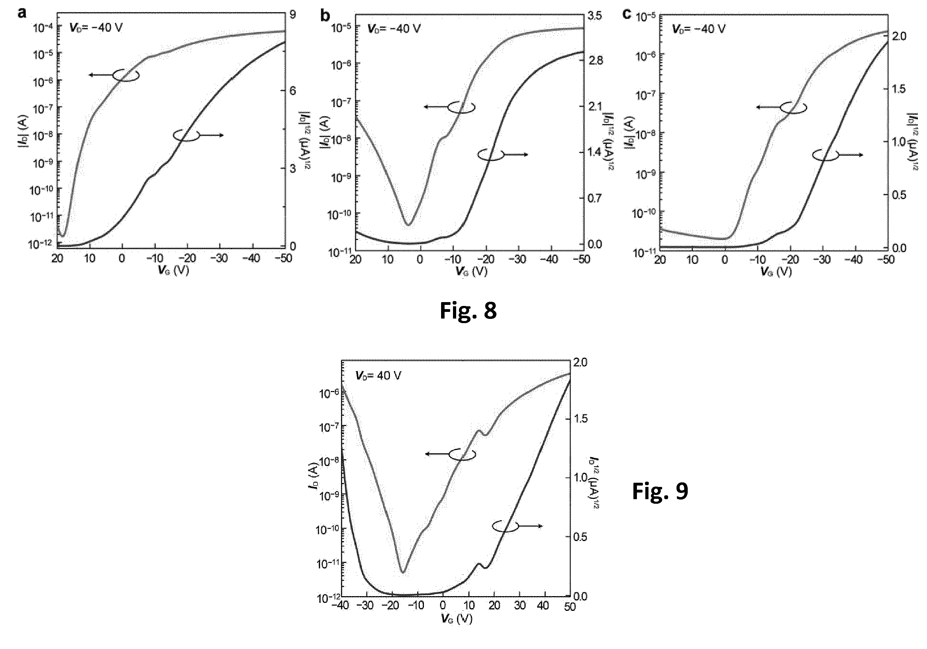

P3HT/chlorobenzene (2.5 mg/ml) and PVP/Propylene glycol methyl ether acetate (120 mg/ml) were spin-coated onto the nanomesh scaffold in sequence. Before spin-coating PVP, the substrate periphery was cleaned by a cotton bud soaked in chloroform in order to improve wettability. Then oxygen plasma treatment was performed to selectively burn off the PVP/P3HT layer on top of nanomesh. The etching dose was verified by AFM characterization. The residual PVP could be washed away by ethanol. The electrical performances of all the modification layers, i.e., P3HT, F8T2 and IIDDT-C3, were explored by integrating them in bottom-contact bottom-gate OFET devices (Fig. 8; Fig. 9 and Table 4).

### Hierarchical assembling of full-coverage PTCDI-C8 NWs film

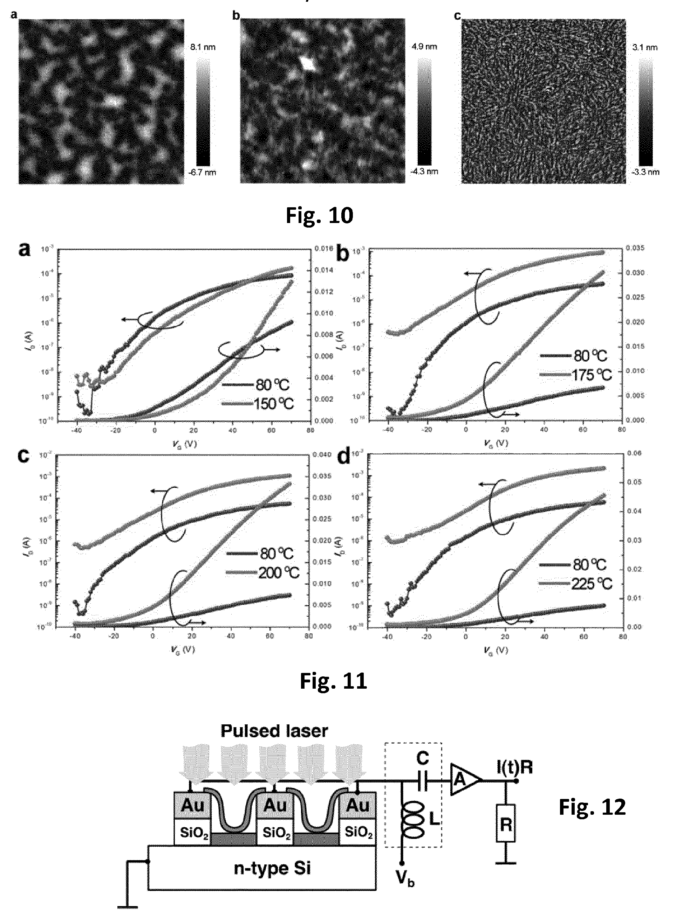

For the first step, 0.25 mg/ml PTCDI-C8 solution in chloroform were prepared. Then 200 µL of PTCDI-C8 solution was injected into 3 ml of alcohol solvent. Supramolecular nanowire formation occurs within seconds because molecular interactions are favoured in the non-solvent. The SMNWs were carefully collected and dispersed again in a solvent mixture of hexane/ethanol (3:1). The dispersion was dropped onto water surface to form floating nanowire film, which was compressed by 50 µL PVP/Ethyl acetate (100 mg/ml) before transferring the SMNWs onto the substrate. Although water is involved during device fabrication, the moisture does not seem to affect the electrical properties of hierarchically assembled PTCDI-C8 NWs, which exhibited typical n-type transfer curve in OFETs (Fig. 11). The on/off ratio could reach 10⁵ upon annealing at 80°C inside N₂ glovebox. The drain current would increase steadily after further annealing with elevated temperature from 150°C to 225°C at a step of 25°C due to the improved molecular ordering (Fig. 11).

### Example 2: Properties of a device according to the invention

Properties of a device according to example 1 were measured.

### Optoelectronic measurement

All the optoelectronic characterization was performed inside nitrogen filled glovebox. For the irradiation, Polychrome V as monochromatic source was used, which was purchased from Till Photonics. The output power spectrum has been calibrated by The PM100A Power Meter from Thorlab company. Coupled with monochromatic light source, Keithley 2636A system source meter was used to make electrical characterization.

### Transient photocurrent measurements

Transient photocurrent measurements were performed by applying a DC voltage (*V*_{b}) ranging from -1.5 V to 1.5 V between highly doped n-type Si substrate and top Au nanomesh (cathode). The Si substrate is referred as an anode and was connected to zero potential. The AC signal from the cathode, separated by a circuit comprising a capacitor and a coil (bias-T) was connected to a 2 GHz current amplifier (the schematic of the measurement setup is shown in the inset of Fig. 12). The charge carriers were created by a pulsed laser impinging perpendicular to the top Au surface. The laser pulse duration was 3-4 ns, and its repetition rate was 10 Hz. The samples were measured upon irradiation at λ = 500 nm. The time dependence of the photocurrent (*I*(t)) was recorded by a 2.5 GHz oscilloscope. The zero-time was set to the beginning of the laser pulse, which was determined from the intersection of the dark current and rising slope of the *I(t).* Here *I*(t) curve has been smoothed and background *I*(t) from an empty nanomesh scaffold without SMNWs has been removed. All measurements were performed in a nitrogen atmosphere with H₂O and O₂ levels below 10 ppm. All devices were tested in terms of current-voltage characteristics prior to the transient photocurrent characterization.

### Example 3: Effect of different fiber thickness

According to this example, identical SMNWs film were deposited onto different nanomesh scaffold patterned by nanospheres with diameter of 480 nm, 600 nm, 800 nm or 1100 nm. The /_{SC} and *V*_{OC} values are summarized in Table 1. By keeping all the remaining geometrical parameters unchanged, it has been found that larger nanoholes provide greater space for NWs to bend and ultimately make a suitable physical (i.e. electrical) contact with Si. In accordance to the prediction that the photocurrent should be proportional to the area of NWs/Si interface, we found that *I*_{SC} increases when larger hole diameters are used (Table 1), for a given set of SMNWs grown in methanol and ethanol as non-solvent..

**Table 1| Photovoltaic property dependence on geometrical parameters**

| Samples:^{a} | Responsivity^{b} | *(R, V*_{OC} (V) | |
|---|---|---|---|
| Sphere diameter/ | µA/W) | | |
| solvent type | | | |
| 480 nm/methanol | 0.113 | 0.14 | |
| 600 nm/methanol | 0.393 | 0.18 | |
| 800 nm/methanol | 0.868 | 0.22 | |
| 1100 nm/methanol | 1.30 | 0.23 | |
| 480 nm/ethanol | 0.174 | 0.14 | |
| 600 nm/ethanol | 0.717 | 0.19 | |
| 800 nm/ethanol | 0.903 | 0.20 | |
| 1100 nm/ethanol | 1.732 | 0.23 | |

| | | | |
|---|---|---|---|
| ^{a} Thermal treatment at 150°C for 30 minutes; ^{b}*R* value is measured under 525 nm green light with the power density of 167.7mW/cm². | | | |

### Example 4: Photovoltaic response of a device according to the invention

According to this example, different anode modification layers were evaluated for photovoltaic response. The results are given in Table 2.

**Table 2| Photovoltaic response of PTCDI-C8 SMNWs with different anode modification layer**

| Samples | EQE^{a} (100%) | *V*_{OC} (V) | FF | PCE^{a} | *R*^{a}(mA/W) | *R*^{b}(mA/W) |
|---|---|---|---|---|---|---|
| Si-n⁺ | 0.11% | 0.15 | 0.36 | 0.0027% | 0.443 | 0.428 |
| P3HT | 53.8% | 0.30 | 0.30 | 2.2% | 216.8 | 206.8 |
| F8T2 | 41.6% | 0.39 | 0.29 | 2.1% | 167.6 | 117.2 |
| IIDDT-C3 | 22.3% | 0.49 | 0.26 | 1.3% | 89.87 | 84.91 |

| | | | | | | |
|---|---|---|---|---|---|---|
| ^{a} The EQE, PCE and responsivity (R) are obtained by using P = 2.43 mW/cm² at = 500 nm. ^{b} Responsivity measured under 525 nm light illumination in order to minimize F8T2 contribution to the PTCDI-C8 NWs photovoltaics. All the current related data were calibrated by considering a surface coverage factor of 4.05% in order to evaluate the intrinsic photovoltaic process in SMNWs. | | | | | | |

### Example 5: Effect of NWs conformity and nanomesh roughness on Photovoltaic performance

The geometry according to the invention was used to incorporate large-area and full-coverage nanowires films produced through hierarchical assembly (Fig. 1i). In particular, PTCDI-C8 molecules were self-assembled into supramolecular nanowires by solvent-induced precipitation (SIP). Then, the obtained NWs were organized into quasi-monolayer thick films floating at the water/air interface. Before transferring them onto the nanomesh scaffold, 50 µL of PVP solution (ethyl acetate; 100 mg/ml) was dropped onto the water surface to compress the floating SMNWs into uniform films. Compared to spin-coating, this assembling approach has two advantages: *i*) the SMNWs can be even distributed on surfaces, as confirmed by fluorescence microscopy, and *ii*) 100% of material can be deposited at surfaces, without any waste.

SEM images of full-coverage SMNWs on top of a nanomesh scaffold reveal that almost every nanohole is accommodating NWs. The SEM images show that the nanowire starts to make conformal contact with the underlying electrode only at distance of ca. 150 nm from the hole edge, regardless of the hole diameter. Hence, the nanowire is partially suspended between the electrodes before the contact is made. Accordingly, the real junction area between NWs and the underlying silicon electrode is ∼300 nm shorter than it appears from the top view. This observation is of utter importance for understanding how the actual contact area will be determined later on.

After PTCDI-C8 NWs deposition and thermal annealing inside glovebox, photovoltaic effect was successfully observed which could be attributed to the light absorption by PTCDI-C8 SMNWs. During the measurement, Si is grounded to 0 V, so we can define the gold nanomesh as cathode according to the photocurrent direction. Since PTCDI-C8 is an n-type semiconductor, the excitons should separate at NWs/Si interface. Then photo-generated charges are efficiently transported though the nanowires and are collected at the gold cathode. Thin film X-ray diffraction (XRD) analysis was also carried out to shed light on the molecular stacking in these SIP-derived SMNWs

### Example 6: Calibrating the real p-n interface of NWs photovoltaic device

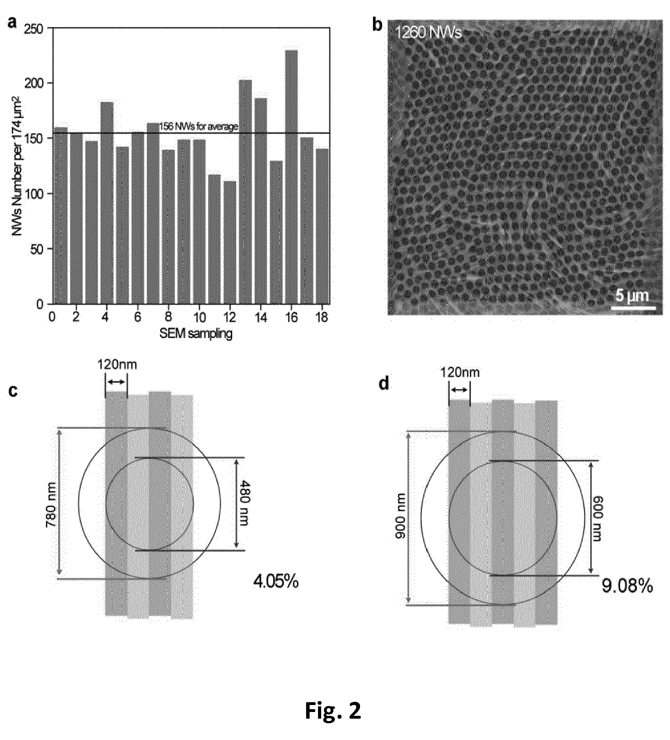

Figure 2 shows estimation of the contact area between the NWs and the bottom electrode.
**a)** Statistics obtained from 18 individual SEM images overall sampling an area of 0.07 cm² NWs based device. In average there are 156 NWs in 174 µm² surface area visualized in each SEM image, with nanohole diameters of ∼780 nm.
**b)** AFM image of a small area NWs photovoltaic device. In this specific image there are 1260 NWs on the top of 784 µm² (28 µm × 28 µm) device area. In this case, the nanohole diameter amounts to 900 nm (this value is determined from the SEM image.
c) For large area supramolecular NWs device in panel a) the size of the nanohole is ∼780 nm. Only 480 nm (i.e. 300 nm smaller than the whole hole diameter) round region in the center physically contact the NWs, thus form an efficient exciton separation interface with PTCDI-C8 nanowires. As we shown by four color stripes, in 480 nm there is enough space for at most *4* nanowires packed parallel one another on top of the efficient round region. In such a scenario for each NW (120 nm wide) the exciton dissociation interface can be mathematically estimated to be: ((480 nm/2)²×π)/***4***. As a result, 4.05% of the device surface is occupied by the effective p-n junction. **d)** Because nanohole diameter for small surface device increased to 900 nm (calibrated from the SEM), the region for effective exciton separation interface (i.e. 600 nm round region in the center) can host up to *5* nanowires. Using similar assumption, each nanowire inside the nanohole would occupy ((600 nm/2)²×π)/***5***. As a result, 9.08% of the whole nanomesh device surface is occupied by PTCDI-C8/P3HT interface. The much larger filling ratio for small area device compared to the large area device is due to two reasons: 1) The smaller area device creates nearly perfect hexagonally closely-packed hole arrays extended over hundreds of micrometers area, so there is higher nanohole density. 2) The hole diameter increases from 780 nm to 900 nm for the small area device; as a result, the probability for the nanowires to form intimate contact with the bottom electrode naturally increases.

### Example 7: Calibrated photovoltaic properties of SMNWs photonic devices

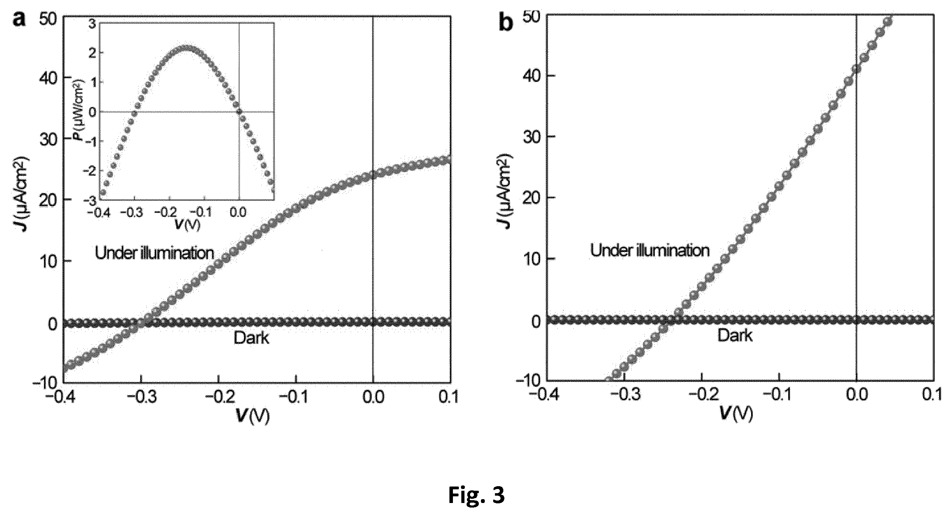

Figure 3 shows Optimized photovoltaic *J*-*V* curves
**a)** Device with relatively large surface area of 0.07 cm². The inset portrays the output power curve at different voltage. After calibration, the PCE could reach a peak value of 2.2% (500 nm green light; 2.43 mW/cm²). The best photo responsivity amounts to 223.2 mA/W, which corresponds the external quantum efficiency of 55.4%. **b**) *J*-*V* curves under identical illumination condition for smaller device with 784 µm² surface area. After calibration, both the large area and small area device exhibit similar EQE value. Here we should note that the PCE of 2.2% was obtained under monochromatic green light rather than a standard AM 1.5 solar light. Such value was calculated following an accurate calibration obtained by dividing by a factor of 4.05% in order to evaluate the potential energy conversion capability afforded by the neat PTCDI-C8 SMNWs.

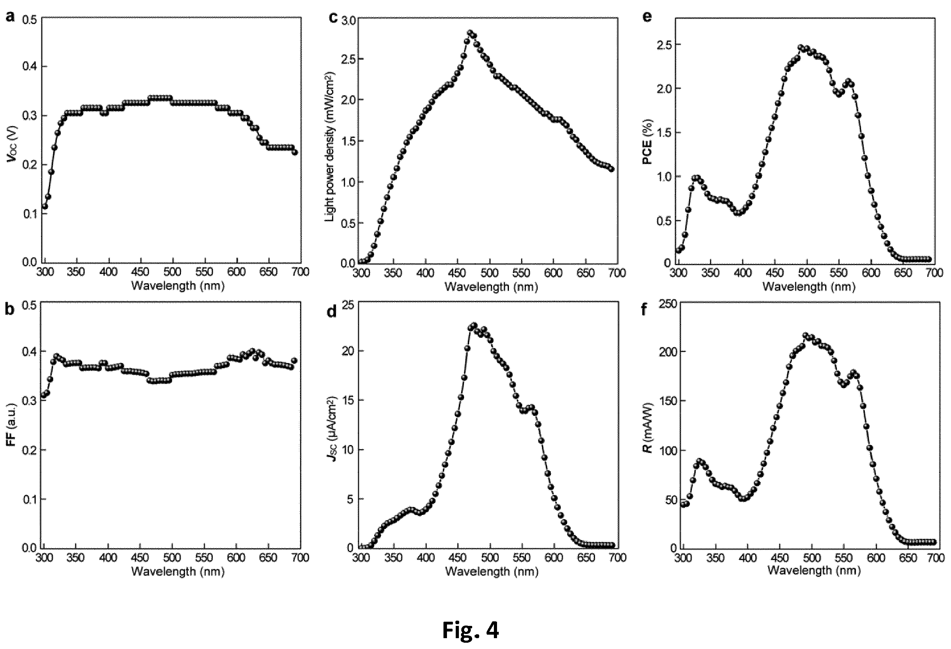

Figure 4 shows the main parameters of SMNWs/P3HT photovoltaic device as a function of irradiation wavelength. **a)** Open circuit voltage (*V*_{OC}) versus wavelength. **b)** Fill factor (FF) versus wavelength. **c)** Light power density spectrum of the monochromatic light source. **d)** Short circuit current density (*J*_{SC}) versus wavelength (photocurrent divided by the device surface of 0.07 cm²). **e)** Power conversion efficiency (PCE) versus wavelength. **f)** Responsivity (*R*) versus wavelength. These results are extracted from a well-performing SMNWs/P3HT device by tracing *I*-*V* curves (-0.4 V to 0.1 V) upon varying the irradiation wavelength from 300 nm to 690 nm [in steps of 5 nm]. A PCE exceeding 2% is achieved when the device is illuminated by a monochromatic light with a wavelength ranging between 450 nm to 570 nm.

### Example 8: I-V curves in dark and under illumination with very weak light

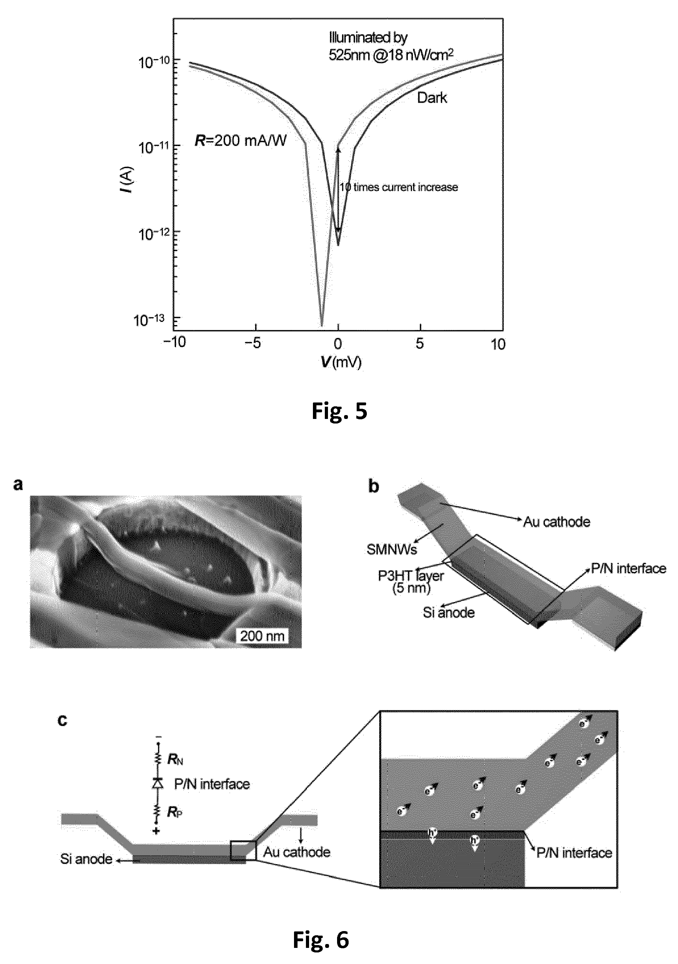

Figure 5 shows the photovoltaic effect when irradiated by ultralow light power of 0.018 µW/cm². The responsivity of ∼200 mA/W is comparable to 223.2 mA/W under relatively high irradiation power of 2.43 mW/cm², suggesting near linear light response in a wide light power range of 10⁴.

### Example 9: Origin of contact resistance with SMNWs photovoltaic devices: analysis and possible solutions

Figure 6 shows **a)** SEM image of single supramolecular nanowire accommodated inside a nanohole. **b)** Device configuration of functional regions (3D model). **c)** Side view of the functional region of SMNWs photonic device and the equivalent circuit where ***R***_{N} and ***R***_{P} include all of the parasitic resistive contributions coming from the bulk resistance of the NW (for the N part) and semiconductor/electrode interface (for the N and P part).
As displayed in Fig. 6, the SMNWs photonic device could be divided into three main parts: i) The key P/N interface, which is responsible for exciton dissociation and photocurrent generation. ii) The hole transporting material connecting the P/N interface to the anode. iii) The nanowire part connecting the P/N interface to the cathode.

### Example 10: Transient photoresponse in PC mode for bare nanomesh scaffold

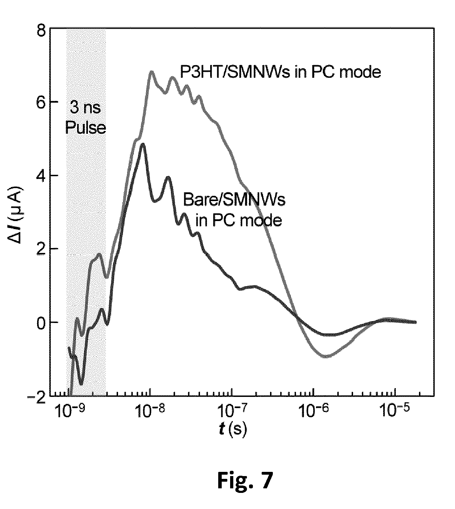

Figure 7 shows a fast photo response under 1.5 V bias voltage in PTCDI-C8 SMNWs on nanomesh scaffold with and without P3HT modification layer.

### Example 11: Field-effect transistor performance of different anode modification layers and the relationship between FF and polymer mobility

**Table 3: The average photovoltaic parameters upon irradiation with P = 2.43 mW/cm² (λ = 500 nm)**

| .Samples^{a} | EQE (100%) | PCE (100%) | *R* (mA/W) | *V*_{OC} (V) | FF |
|---|---|---|---|---|---|
| P3HT | 53.8% | 2.2% | 217.0 | 0.31 | 0.329 |
| F8T2 | 48.0% | 1.9% | 193.4 | 0.37 | 0.262 |
| IIDDT-C3 | 22.6% | 1.1% | 90.9 | 0.47 | 0.256 |

| | | | | | |
|---|---|---|---|---|---|
| ^{a} The average values indicated in this table were calculated from four SMNWs photonic devices in the same batch for each sample. The measurements are performed by tracing the *I*-*V* curve upon irradiation at λ =500 nm on the device. As a comparison, the photo responsivities in Table 2 are obtained by recording the short circuit current of a single device at different irradiation wavelengths. | | | | | |

Figure 8 shows P-channel OFET transfer curves of three anode modification layers, a) P3HT, b) IIDDT-C3 and, c) F8T2 in bottom-contact bottom-gate configuration. The channel length of interdigitated electrodes was 2.5 µm. The SiO₂ was functionalized with hexamethyldisilane (HMDS). All the polymer films were prepared in identical conditions as those presented in the manuscript for the anode modification, i.e., 2.5 mg/ml concentration in chlorobenzene, spin-coated at 5000 rpm, then annealed inside glovebox at 180 °C for 1 hour before electrical measurement.

Figure 9 shows *I*_{d}*-V*_{g} curve for a bottom-gate bottom-contact transistor with IIDDT-C3 as the active layer. The ambipolar behavior allows electrons to transfer from PTCDI-C8 SMNWs back to anode modification layer of IIDDT-C3 as reverse current against photocurrent.

**Table 4| OFET properties of three modification layers**

| Samples^{a} | µₕ (cm²/V.s) | µₑ (cm²/V.s) | *I*ₒₙ/I_{off} | *V*_{T} (V) | *R*_{RMS} (nm) |
|---|---|---|---|---|---|
| P3HT | 1.5×10⁻³ | - | 10⁸ | 5 | 2.32 |
| F8T2 | 1.7×10⁻⁴ | - | 10⁵ | -18 | 1.27 |
| IIDDT-C3 | 6.×10⁻⁴ | 6.3×10⁻⁵ | 10⁵ | -10 | 0.973 |

| | | | | | |
|---|---|---|---|---|---|
| ^{a} *I*ₒₙ/I_{off} and V_{T} are obtained from Fig. S17 and S18. Root mean square roughness (*R*_{RMS}) is obtained from Fig. S19. Hole mobility (µₕ) and electron mobility (µₑ) are calculated from an average of 8 devices measured in the saturation regime. | | | | | |

Since P3HT exhibits the highest mobility, the SMNWs photonic device modified with P3HT layer shows the highest FF (0.329) due to the lower contact resistance as discussed for Fig. 6. On the other hand, the F8T2-modified devices show a lower FF (0.262) as a result of the lowest mobility among the three polymers. As for IIDDT-C3, although the mobility is higher than that of F8T2, the ambipolar behavior might be responsible for the poorest FF in terms of reverse current for IIDDT-C3 modified device (Fig. S18).

Figure 10 shows a film morphology of three modification layers characterized by AFM. a) P3HT. b) F8T2 and, c) IIDDT-C3. All these topography AFM images are scanning an area of 4 × 4 µm². The R_{RMS} has been summarized in Table S2. These AFM images suggest a polycrystalline nature of all the three kinds of polymeric films.

### Example 12: Field-effect transistor performance of PTCDI-C8 SMNWs deposited by water-floating method

Figure 11 shows OFETs based on full-coverage PTCDI-C8 NWs in bottom-contact bottom gate device geometry. Blue lines represent the original transfer curve before high temperature annealing. Red lines represent the transfer curve after thermal treatment at **a)** 150°C, **b)** 175°C, **c)** 200 °C, and **d)** 225 °C. Thermal treatment at 225 °C leads to a 49-fold increase in the electron mobility, yet the on/off ratio degrades from 10⁵ to 10³.

## Claims

1. Device comprising a top electrode and a bottom electrode, wherein said top electrode comprises nanoholes and wherein said device comprises nanowires comprising alternative contact areas with said top electrode and with said bottom electrode, said contact areas on the top electrode being (i) located on the top surface of said top electrode and said contact areas on the bottom electrode being (i) located on the top surface of the bottom electrode facing the top electrode and (ii) located in nanoholes of said top electrode.

2. Device according to claim 1, wherein said nanowires comprise one or more self-assembled n-type semiconductors.

3. Device according to claim 1 or 2, wherein said nanowires are curvilinear.

4. Device according to any one of claims 1 to 3, wherein said nanowires form a film on the surface of the top electrode.

5. Device according to any one of claims 1 to 4, wherein said nanowires are connected to asymmetric electrodes.

6. Device according to any one of claims 1 to 5, wherein said nanowires present a diameter of from 1 to 600 nm, preferably from 5 to 200 nm, for example from 20 to 70 nm.

7. Device according to any one of claims 1 to 6, wherein contact areas are of from 1 to 20% of the total electrode surface.

8. Device according to any one of claims 1 to 7, wherein top electrode comprises more two, preferably at least four, nanowires in a single nanohole.

9. Device according to any one of claims 1 to 8, wherein said device comprises a bottom electrode in contact and superimposed with a dielectric layer, wherein inside said nanoholes a semiconducting layer is in contact and superimposed with the bottom electrode.

10. Device according to any one of claims 1 to 9, wherein said top electrode presents an array of hexagonal nanoholes.

11. Device according to any one of claims 1 to 10, wherein said device presents a layer of one or more semiconducting components inside said nanoholes, on the bottom electrode top surface.

12. A method or process for fabricating a device according to any one of claims 1 to 11, said method of process comprising:
(a) Preparing a scaffold comprising nanoholes in a top electrode, said top electrode being on the top surface of a bottom electrode,
(b) Preparing a film of nanowires;
(c) Depositing said film of nanowires on the top surface of the top electrode;
(d) Contacting said nanowires by alternative contact areas with said top electrode and with said bottom electrode, said contact areas on the top electrode being (i) located on the top surface of said top electrode and said contact areas on the bottom electrode being (i) located on the top surface of the bottom electrode facing the top electrode and (ii) located in nanoholes of said top electrode.

13. The method or process according to claim 12, wherein said step a) of preparing a scaffold comprising nanoholes, comprises preparing a top electrode and forming nanoholes in said top electrodes by nanospheres lithography.

14. The method or process according to claim 12 or 13, wherein said device comprises a dielectric layer surfacing said bottom electrode, and wherein said method or process comprises removing from said nanoholes said dielectric layer by reactive ion etching.

15. A device according to any one of claims 1 to 11 or obtainable from a method or process according to any one of claims 12 to 14, in an opto-electronic device, including inorganic based photonic devices, inorganic and organic light-emitting diodes, organic light-emitting transistors, solar cells based on perovskite, organic semiconductors and dyes, and water splitting devices.
